(19) Europäisches Patentamt
European Patent Office
Office européen des brevets

(11) **EP 2 592 477 A1**

(12) **EUROPEAN PATENT APPLICATION**

(43) Date of publication:
**15.05.2013 Bulletin 2013/20**

(51) Int Cl.:
***G03F 7/36*** (2006.01)          ***G03F 7/027*** (2006.01)
***G03F 7/38*** (2006.01)

(21) Application number: **11189018.2**

(22) Date of filing: **14.11.2011**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(71) Applicant: **Stichting Dutch Polymer Institute
5612 AB Eindhoven (NL)**

(72) Inventor: **The designation of the inventor has not yet been filed**

(74) Representative: **Renkema, Jaap
IPecunia Patents B.V.
P.O. Box 593
6160 AN Geleen (NL)**

(54) **Continuous process for preparation of a substrate with a relief structure**

(57) The invention relates to a process for the preparation of a substrate coated with a relief structure comprising the steps of a) coating a substrate with a coating composition comprising a polymeric binder, a photoinitiator and a compound having at least two crosslinkable groups per molecule to form a coated substrate and b) exposing said coated substrated to a pulsed light while moving said coated substrate with respect to the pulsed light to obtain a substrate coated with a relief structure. The invention also relates to films, tapes and fibres obtained with said process and to use of these films, tapes and fibres in various applications.

Fig 1.

**Description**

The invention relates to a process for the preparation of a substrate coated with a relief structure, the substrate coated with a relief structure obtainable therewith and to use of said substrate.

The ability to control the surface structure of (thin) polymeric films at a micro- and nanoscale has led to many applications in the areas of photonics, organic electronics, micromechanics and even tissue engineering. Different techniques may be used to create surface relief structures. For example, replication methods based on physical contact may be used, for example by pressing a polymeric film against a microstructure rigid master (N. Stutzmann, T.A. Tervoort, C.W.M. Bastiaansen, K. Feldman, P. Smith Adv. Mater. 2000 12, 557 and G. Fichet, N. Stutzmann, B.V.O.Muir, W.T.S.Huck, Adv.Mater. 2002, 14, 47) or by cast-molding wherein a polymer precursor is poured onto a master, cured and released to obtain an inverse replica (E. Kim, Y.N.Xia, G.M.Whitesides, Nature 1995, 376, 581).

Also, replication methods based on lithography via light-induced solubility changes of a polymeric (coating) composition may be used. For example, 'photoembossing' as e.g. described by C. Sanchez, B-J. de Gans, D. Kozodaev, A. Alexeev, M.J.Escuti, C. van Heesch, T. Bel, U.S.Schubert, C.W.M.Bastiaansen and D.J.Broer, Adv. Mater. 2005, 17, 2567-2571 may be used. In this process, a substrate is coated with a coating composition comprising a polymeric binder, a multireactive acrylate and a photoinitiator. An irradiation step through a lithographic mask, which is in direct contact with the coating, at room temperature generates radicals in the exposed areas. Since monomer diffusion and polymerization cannot occur at room temperature, a free-radical latent image of the lithographic mask is formed. By subsequent heating, the monomer mobility and polymerization in the irradiated areas is enhanced. Due to consumption of the monomers in these regions, a net flux of monomer from the unexposed to the exposed areas occurs, resulting in a surface deformation.

However, for many practical applications of substrates having a relief structure, the throughput of the substrates is not high enough and consequently these applications are not economically attractive.

S.H. Ahn and L.J. Guo, describe in 'high-speed roll-to-roll nanoimprint lithography on flexible plastic substrates' Adv. Mater.2008, 20, 2044-2049 continuous printing of nanostructures (relief structures) using mechanical embossing, wherein a mold material is pressed into a coating composition, wherein both the mold material and the coating composition are present on a roll, the coating composition is cured and the mold is separated from the roller via a release roller. However, such process requires the use of a mold material, which tends to show significant sticking to the coating composition, unless the substrate is pretreated. Also, it is difficult to imprint small structures with a high relief, since these patterns are mechanically more fragile and may break and/or stick to the mold when removing the mold material.

Therefore, it is an object of the invention to provide a process for continuous preparation of relief structures which overcomes the above mentioned disadvantages.

This object is achieved by a process for the preparation of a substrate coated with a relief structure comprising the steps of

> a) coating a substrate with a coating composition comprising a polymeric binder, a photoinitiator and a compound having at least two crosslinkable groups per molecule to form a coated substrate and
> b) exposing said coated substrate to a pulsed light, which light is capable of activating the photoinitiator while moving said coated substrate with respect to the source of the pulsed light to obtain a substrate coated with a relief structure.

It has been found that with the process of the invention, substrates coated with a relief structure can be prepared in a continuous, efficient and commercially attractive way. The process of the invention is also suitable for preparing small relief structures and does not require the (difficult) removal of mold material.

Furthermore, the process of the invention may make it possible to control and/or enhance the relief height of the relief structure. Relief height can be measured using atomic force microscopy (AFM) in semi-contact mode as described in the experimental section herein. Moreover, the process of the invention may provide relief structures having an increased sharpness as determined from AFM images, for example by quantifying the smoothness of the surface and/or the amount of surface defects present in the relief structure.

The pulsed light may for example be a coherent light, for instance a laser light. The light may be used as such for exposure of the coated substrate, but may also be used in the form of a light pattern, for example a pattern created by a mask or by an interference pattern. For example, the pulsed light pattern may be a pulsed interference pattern created by two coherent electromagnetic radiation beams.

The duration of the pulses of the light may for example be chosen from 2 to 10ns. Dependent on the duration of the pulses, the frequency of the pulses of the light may for example be chosen from 2 to 10ns$^{-1}$.

The substrate may be moved with respect to the pulsed light, for example a pulsed interference pattern created by two pulsed laser beams by any means, for example by using a stationary position for the pulsed interference pattern and by moving the substrate with respect to the pattern on a transporter belt, by using a roll-to-roll process, by using winders, by moving a stage or by any other technique.

Preferably, the substrate is moved parallel to the grating vector.

In order to create a uniform relief pattern, the coated substrate is preferably moved such that the smallest distance from the light source, that is the source that creates the pulsed light to the substrate does not (substantially) change.

The speed with which the coated substrate is moved with respect to the source of the pulsed light is also referred to herein as line speed. The line speed of the coated substrate is preferably as high as possible to reduce production cost. Line speeds that may for example be used in the process of the invention are speeds of for example at least 0.1, for example at least 0,5. for example at least 1, for example at least 2, for example at least 5 and/or for example at most 10 m/min.

The substrate may be coated with the coating composition using any process known in the art of (wet) coating deposition. Examples of suitable processes are spin coating, dip coating, spray coating, flow coating, meniscus coating, slit die coating, doctor's blading, capillary coating, roll coating and bicomponent extrusion techniques.

Preferably, the process of the invention further comprises step c) of subsequently heating the product obtained in step b).

The process of the invention may (also) further comprises step d) of curing the product obtained in step b) or the product obtained in step c).

Preferably, in the process of the invention, step c) is performed after step b) without an intervening step. Preferably, in the process of the invention, step d) is performed after step b) or after step c) without an intervening step.

Therefore, in a preferred embodiment, the invention relates to a process for the preparation of a substrate coated with a relief structure comprising the steps of

a) coating a substrate with a coating composition comprising a polymeric binder, a photoinitiator and a compound having at least two crosslinkable groups per molecule to form a coated substrate

b) exposing said coated substrate to a pulsed light, for example to a pulsed interference pattern created by two pulsed coherent electromagnetic radiation beams, while moving said substrate with respect to the pulsed interference pattern to obtain a coated substrate with a latent image and subsequently

step

c) of subsequently heating the product obtained in step b) and subsequently

d) curing the product obtained in step c).

The coating composition with which the substrate is coated comprises a polymeric binder, a photoinitiator and a compound having at least two crosslinkable groups per molecule.

The coating composition with which the substrate is coated comprises a polymeric binder. Within the framework of the invention, with polymeric binder is meant any polymer, that does not phase separate in the coating composition.

Examples of polymeric binders include but are not limited to polymethylmethacrylate, polymethylacrylate, polystyrene, polybenzylmethacrylate, polyisobornylmethacrylate. But also many other polymers may be applied as well.

Preferably, the polymeric binder is of the same nature as the polymer resulting from the crosslinking of the compounds having at least two crosslinkable groups per molecule. Preferably, this polymer binder has a weight-averaged molecular weight (Mw) of at least 20,000 g/mol as determined using GPC (Gas Phase Chromatography).

The polymeric binder preferably has a glass transition temperature (Tg) of at least 300K. The glass transition temperature as defined herein is determined using DSC as described herein. Specifically, the measurement of Tg is performed by using a TA Instruments Q 1000 DSC with a RCS2-90 cooling unit. Measurements are done in $N_2$ atmosphere and the apparatus is calibrated with indium, zinc and water. The software used for operating the machine and analyzing the thermograms is the Q-Series Advantage version 2.8.0394 from TA Instruments. A sample of approximately 10 mg sealed in aluminium DSC pans is heated up from 0 °C up to 300 °C at a heating rate of 5 °C/ min. The Tg is determined with the software. The amount of polymeric binder in the coating composition is in principle not critical and may for example be chosen from 10 to 90 %w/w based on polymeric binder and compound having at least two crosslinkable groups, for example the amount of polymeric binder is at least 25, for example at least 35, for example at least 45 and/or at most 80, for example at most 70, for example at most 60% w/w based on polymeric binder and compound having at least two crosslinkable groups.

It is clear that also mixtures of polymeric binder may be used in the coating composition as used in the process of the present invention.

The coating composition with which the substrate is coated comprises a photoinitiator. Examples of photoinitiators include but are not limited to photoinitiators as commercially available from for example CIBA Specialty Chemicals (Germany).

When UV-crosslinking is used to initiate crosslinking, the mixture preferably comprises a UV-photo-initiator. A photo-initiator is capable of initiating a crosslinking reaction upon absorption of light; thus, UV-photo-initiators absorb light in the Ultra-Violet region of the spectrum. Any known UV-photo-initiator may be used in the process according to the invention.

The amount of photoinitiator may vary between wide ranges. A suitable amount of photoinitiator is for example between above 0 and 10, for example between above 0.1 and 5 wt% with respect to total weight of the compounds that take part in the crosslin king/cu ring reaction.

The coating composition may further comprise a thermal initiator.

The coating composition with which the substrate is coated further comprises a compound having at least two crosslinkable groups per molecule.

Within the framework of the invention, with crosslinkable groups is meant groups that - upon initiation of the photoinitiator - are capable of reaction with each other to form a network. The compound having at least two crosslinkable groups per molecule may for example be a monomer, preferably a C=C unsaturated monomer that is polymerizable via electromagnetic radiation.

The compound having at least two crosslinkable groups per molecule may also be a mixture of compounds having at least two crosslinkable groups per molecule. It is to be understood that also mixtures of compounds having different amounts of crosslinkable groups per molecule may be used in the coating composition, for example a mixture of compounds having two crosslinkable groups per molecule with compound having three, four and/or five crosslinkable groups per molecule.

The monomer is preferably a compound of relatively low molecular weight, i.e. smaller than 1500 daltons, that reacts via free radical or cationic polymerization.

Examples of monomers having at least two crosslinkable groups are monomers containing reactive groups of the following classes: vinyl, acrylate, methacrylate, epoxide, vinylether, oxetane or thiol-ene or of mixtures thereof.

Examples of such monomers include but are not limited to monomers containing (meth)acryloyl groups such as trimethylolpropane tri(meth)acrylate, pentaerythritol (meth)acrylate, ethylene glycol di(meth)acrylate, tetraethylene glycol di(meth)acrylate, polyethylene glycol di(meth)acrylate, 1,4-butanediol di(meth)acrylate, 1,6-hexanediol di(meth)acrylate, neopentyl glycol di(meth)acrylate, polybutanediol di(meth)acrylate, tripropyleneglycol di(meth)acrylate, glycerol tri(meth)acrylate, phosphoric acid mono- and di(meth)acrylates, $C_7$-$C_{20}$ alkyl di(meth)acrylates, trimethylolpropanetrioxyethyl (meth)acrylate, tris(2-hydroxyethyl)isocyanurate tri(meth)acrylate, tris(2-hydroxyethyl)isocyanurate di(meth)acrylate, pentaerythritol tri(meth)acrylate, pentaerythritol tetra(meth)acrylate, dipentaerythritol monohydroxy pentacrylate, dipentaerythritol hexacrylate, tricyclodecane diyl dimethyl di(meth)acrylate and alkoxylated versions, preferably ethoxylated and/or propoxylated, of any of the preceding monomers, and also di(meth)acrylate of a diol which is an ethylene oxide or propylene oxide adduct to bisphenol A, di(meth)acrylate of a diol which is an ethylene oxide or propylene oxide adduct to hydrogenated bisphenol A, epoxy (meth)acrylate which is a (meth)acrylate adduct to bisphenol A of diglycidyl ether, diacrylate of polyoxyalkylated bisphenol A, and triethylene glycol divinyl ether, adduct of hydroxyethyl acrylate, isophorone diisocyanate and hydroxyethyl acrylate (HIH), adduct of hydroxyethyl acrylate, toluene diisocyanate and hydroxyethyl acrylate (HTH), and amide ester acrylate.

Additionally, the coating composition may further comprise a monomer having only one crosslinkable group per molecule; such monomer is also referred to herein as 'reactive diluent'.

Examples of monomers having only one crosslinking group per molecule include monomers containing a vinyl group, such as N-vinyl pyrrolidone, N-vinyl caprolactam, vinyl imidazole, vinyl pyridine; isobornyl (meth)acrylate, bornyl (meth)acrylate, tricyclodecanyl (meth)acrylate, dicyclopentanyl (meth)acrylate, dicyclopentenyl (meth)acrylate, cyclohexyl (meth)acrylate, benzyl (meth)acrylate, 4-butylcyclohexyl (meth)acrylate, acryloyl morpholine, (meth)acrylic acid, 2-hydroxyethyl (meth)acrylate, 2-hydroxypropyl (meth)acrylate, 2-hydroxybutyl (meth)acrylate, methyl (meth)acrylate, ethyl (meth)acrylate, propyl (meth)acrylate, isopropyl (meth)acrylate, butyl (meth)acrylate, amyl (meth)acrylate, isobutyl (meth)acrylate, t-butyl (meth)acrylate, pentyl (meth)acrylate, caprolactone acrylate, isoamyl (meth)acrylate, hexyl (meth)acrylate, heptyl (meth)acrylate, octyl (meth)acrylate, isooctyl (meth)acrylate, 2-ethylhexyl (meth)acrylate, nonyl (meth)acrylate, decyl (meth)acrylate, isodecyl (meth)acrylate, tridecyl (meth)acrylate, undecyl (meth)acrylate, lauryl (meth)acrylate, stearyl (meth)acrylate, isostearyl (meth)acrylate, tetrahydrofurfuryl (meth)acrylate, butoxyethyl (meth)acrylate, ethoxydiethylene glycol (meth)acrylate, benzyl (meth)acrylate, phenoxyethyl (meth)acrylate, polyethylene glycol mono (meth)acrylate, polypropylene glycol mono(meth)acrylate, methoxyethylene glycol (meth)acrylate, ethoxyethyl (meth)acrylate, methoxypolyethylene glycol (meth)acrylate, methoxypolypropylene glycol (meth)acrylate, diacetone (meth)acrylamide, beta-carboxyethyl (meth)acrylate, phthalic acid (meth)acrylate, isobutoxymethyl (meth)acrylamide, N,N-dimethyl (meth)acrylamide, t-octyl (meth)acrylamide, dimethylaminoethyl (meth)acrylate, diethylaminoethyl (meth)acrylate, butylcarbamylethyl (meth)acrylate, n-isopropyl (meth)acrylamide fluorinated (meth)acrylate, 7-amino-3,7-dimethyloctyl (meth)acrylate, N,N-diethyl (meth)acrylamide, N,N-dimethylaminopropyl (meth)acrylamide, hydroxybutyl vinyl ether, lauryl vinyl ether, cetyl vinyl ether, 2-ethylhexyl vinyl ether; and compounds represented by the following formula (I)

$$CH_2=C(R^6)\text{-}COO(R^7O)_m\text{-}R^8 \qquad (I)$$

wherein $R^6$ is a hydrogen atom or a methyl group; $R^7$ is an alkylene group containing 2 to 8, preferably 2 to 5 carbon atoms; and m is an integer from 0 to 12, and preferably from 1 to 8; $R^8$ is a hydrogen atom or an alkyl group containing 1 to 12, preferably 1 to 9, carbon atoms; or, $R^8$ is a tetrahydrofuran group- comprising alkyl group with 4-20 carbon atoms, optionally substituted with alkyl groups with 1-2 carbon atoms; or $R^8$ is a dioxane group-comprising alkyl group with 4-20 carbon atoms, optionally substituted with methyl groups; or $R^8$ is an aromatic group, optionally substituted with $C_1$-$C_{12}$ alkyl group, preferably a $C_8$-$C_9$ alkyl group, and alkoxylated aliphatic monofunctional monomers, such as ethoxylated isodecyl (meth)acrylate, ethoxylated lauryl (meth)acrylate, and the like.

Examples of compounds having at least two crosslinkable groups also include oligomers and polymers. Oligomers and polymers suitable for use in the coating composition are for example aromatic or aliphatic urethane acrylates or oligomers based on phenolic resins (for example bisphenol epoxy diacrylates), and any of the above oligomers chain extended with ethoxylates. Urethane oligomers or polymers may for example be based on a polyol backbone, for example polyether polyols, polyester polyols, polycarbonate polyols, polycaprolactone polyols, acrylic polyols, and the like. These polyols may be used either individually or in combinations of two or more. There are no specific limitations to the manner of polymerization of the structural units in these polyols. Any of random polymerization, block polymerization, or graft polymerization is acceptable. Examples of suitable polyols, polyisocyanates and hydroxylgroup-containing (meth)acrylates for the formation of urethane oligomers are disclosed in WO 00/18696, which is incorporated herein by reference.

Combinations of compounds that together may result in the formation of a crosslinked phase and thus in combination are suitable to be used as the reactive diluent are for example carboxylic acids and/or carboxylic anhydrides combined with epoxies, acids combined with hydroxy compounds, especially 2-hydroxyalkylamides, amines combined with isocyanates, for example blocked isocyanate, uretdion or carbodiimide, epoxies combined with amines or with dicyandiamides, hydrazinamides combined with isocyanates, hydroxy compounds combined with isocyanates, for example blocked isocyanate, uretdion or carbodiimide, hydroxy compounds combined with anhydrides, hydroxy compounds combined with (etherified) methylolamide ("amino-resins"), thiols combined with isocyanates, thiols combined with acrylates or other vinylic species (optionally radical initiated), acetoacetate combined with acrylates, and when cationic crosslinking is used epoxy compounds with epoxy or hydroxy compounds.

Further possible compounds having at least two crosslinkable groups that may be used as a radiation sensitive ingredient are moisture curable isocyanates, moisture curable mixtures of alkoxy/acyloxy-silanes, alkoxy titanates, alkoxy zirconates, or urea-, urea/melamine-, melamine- formaldehyde or phenol-formaldehyde (resol, novolac types), or radical curable (peroxide- or photo-initiated) ethylenically unsaturated mono- and polyfunctional monomers and polymers, e.g. acrylates, methacrylates, maleate/vinyl ether), or radical curable (peroxide- or photo-initiated) unsaturated e.g. maleic or fumaric, polyesters in styrene and/or in methacrylates.

The amount of compound having at least two crosslinkable groups per molecule in the coating composition is in principle not critical and may for example be from 90 to 10% w/w based on polymeric binder and compound having at least two crosslinkable groups, for example the amount of compound having at least two crosslinkable groups is at least 20, for example at least 25, for example at least 30, for example at least 40 and/or at most 90, for example at most 80, for example at most 75, for example at most 70, for example at most 60% w/w based on polymeric binder and compound having at least two crosslinkable groups.

The coating composition comprising a polymeric binder, a photoinitiator and a compound having at least two crosslinkable groups per molecule may further comprise at least one solvent, for example an organic solvent. Such solvent may facilitate the application of the coating composition onto the substrate, such as the formation of thin films by spin coating. Preferably, the conditions as well as the properties of the polymeric binder, and the compound having at least two crosslinkable groups are chosen such that after evaporation of the solvent a solid film is formed.

In principle, a wide variety of solvents may be used. However, the combination of the solvents and all other materials present in the mixture should preferentially form stable suspensions or solutions.

Examples of solvents that are suitable are 1,4-dioxane, acetone, acetonitrile, chloroform, chlorophenol, cyclohexane, cyclohexanone, cyclopentanone, dichloromethane, diethyl acetate, diethyl ketone, dimethyl carbonate, dimethylformamide, dimethylsulphoxide, ethanol, ethyl acetate, m-cresol, mono- and di-alkyl substituted glycols, N,N-dimethylacetamide, p-chlorophenol, 1,2-propanediol,

1-pentanol, 1-propanol, 2-hexanone, 2-methoxyethanol, 2-methyl-2-propanol,

2-octanone, 2-propanol, 3-pentanone, 4-methyl-2-pentanone, hexafluoroisopropanol, methanol, methyl acetate, butyl acetate, methyl acetoacetate, methyl ethyl ketone, methyl propyl ketone, n-methylpyrrolidone-2, n-pentyl acetate, phenol, tetrafluoro-n-propanol, tetrafluoroisopropanol, tetrahydrofuran, toluene, xylene and water. Alcohol, ketone and ester based solvents may also be used, although the solubility of acrylates may become an issue with high molecular weight alcohols. Halogenated solvents (such as dichloromethane and chloroform) and hydrocarbons (such as hexanes and cyclohexanes) are also suitable.

The coating composition may further comprise other components. For example the coaitng composition may further comprise inhibitors or retarders, for example to stabilize the photoinitiator and/or the optional thermal initiator present in the coating composition; chain transfer agents, for example to improve relief heights; or any usual coating composition additives such as fillers, pigments/colorants, surfactants etc or a plasticizer, for example to affect the glass transition temperature (Tg) of the polymeric binder and to enhance diffusional mobility of the compound having at least two crosslinkable groups.

The pulsed light may for example be pulsed coherent electromagnetic radiation, for example a pulsed interference pattern created by two pulsed coherent electromagnetic radiation beams.

The two pulsed coherent electromagnetic radiation beams, may for example be two pulsed laser light beams. Preferably, the electromagnetic radiation used is light in the UV spectrum (10 to 400nm).

For interference holography, typically, two laser beams are combined with an angle of $+\theta$ and $-\theta$ on a coating composition. The resulting interference pattern has a period of $\lambda/2\sin\theta$

(D.Xia, Z.Ku, S.C.Lee, S.R.J.Bruek, *Adv. Mater.* **2011**, 23, 147).

For practical reasons, typically, one laser beam is split into two for instance by using a beam splitter, but it is of course also possible to use two separate lasers.

For example, the coated substrate may be moved with respect to the pulsed interference pattern at a speed of maximally v(max), wherein v(max) is determined by equation (1):

$$v(max) = f_{pulse} \times d_{beam} \times c \qquad\qquad equation\ (1)$$

wherein v(max) stands for the optimal speed of the substrate in $m.s^{-1}$, wherein $f_{pulse}$ stands for the repetition rate of the lasers (Hz) and $d_{beam}$ stands for the width of the laser beams in m and

wherein c stands for the ratio between $d_{hologram}$ and $d_{beam}$ according to the equation (2)

$$c = d_{hologram} / d_{beam} \qquad\qquad equation\ (2)$$

wherein $d_{hologram}$ stands for the size of the beam at the interference region where the sample is placed in m and wherein $d_{beam}$ stands for the width of the laser beams in m .

As used herein, $f_{pulse}$ and $d_{beam}$ are the repetition rate of the laser and the width of the laser beam as given in the specifications by the supplier of the laser.

$d_{hologram}$ is calculated as follows:

$$d_{hologram} = d_{beam} \times MP$$

wherein $d_{beam}$ is as defined above and wherein MP stands for the magnifying power. The value of the magnifying power is listed in the specifications of the beam expander device.

The coated substrate is moved with respect to the interference pattern at a speed of preferably from 0.5 to 2 times v(max), for example at least 0.6, for example at least 0.8, for example at least 0.9 and/or for example at most 1.9, for example at most 1.7, for example at most 1.5 times v(max), for example at most 1.4, for example at most 1.2 times v(max). Preferably, the coated substrate is moved with respect to the pulsed interference pattern at a speed of from 0.8 to 1.4 times v(max), for example from 0.9 to 1.2 times v(max).

The substrate may be exposed from one side only (the side facing the pulsed interference pattern), but may also be simultaneously be exposed on the other side, for example by using a mirror to reflect the pulsed interference pattern on the other side or by using a second interference pattern to expose the other side, for example by splitting a laser beam into 4 laser beams and using 2 of them to form a pulsed interference pattern at one side of the substrate and using the other 2 laser beams to form a pulsed interference pattern at the other side of the substrate. In case the substrate is a fibre (as described below), silicon oil or similar chemicals may be spread onto the surface of the fibre to illuminate also the side of the substrates not facing the pulsed interference pattern.

Step c) of heating the product obtained in step b) may be done by techniques known to the skilled person, for example by heating the product in an environment with a temperature that enables good diffusion of the compound having at least two crosslinkable groups, for example by heating the product obtained in step b) to a temperature above the glass transition temperature (defined and determined as described herein) of the coating composition.

The glass transition temperature of the coating composition as used herein can be determined as described herein. Preferably, the product is heated to a temperature of at least 30°C above the glass transition temperature of the coating composition, for example to a temperature of at most 70°C above the glass transition temperature of the coating composition. The temperature used depends on the heating time used and on the composition of the coating composition. Typical examples of heating time and temperature combinations used include but are not limited to 10 minutes at a temperature from 80°C to 130°C and 15 minutes at a temperature from 70 to 120°C.

Heating may for example be performed by using infrared light. In the continuous process of the invention also the development step may be performed continuously, for example by sliding the product obtained in step b) with the latent image under an IR-lamp with a fixed position or by sliding the IR-lamp over the product obtained in step b) with the latent image.

In case, the process of the invention may further comprises step d) of curing the product obtained in step b) or the product obtained in step c) may for example be done by exposure to electromagnetic radiation, for example UV-light to activate the photoinitiator. In case a thermal initiator is also present in the coating composition, the thermal initiator may also be activated by increasing the temperature of the product obtained in step b) or in step c).

The UV-curing may take place through a free radical mechanism or by a cationic mechanism, or a combination thereof.

Curing of the substrate obtained in step b) or in step c) may for example be performed using UV flood exposure (that is: using an excess of UV-light) and/or heating.

A wide variety of inorganic or organic substrates may be used as a substrate in the process according to the invention.

Suitable substrates are for example flat or curved, rigid or flexible polymeric substrates, including films of for example polycarbonate, polyester, polyvinyl acetate, polyvinyl pyrollidone, polyvinyl chloride, polyimide, polyethylene naphthalate, polytetrafluoro-ethylene, nylon, polynorbornene; or amorphous solids, for example glass or crystalline materials, such as for example silicon or gallium arsenide. Metallic substrates may also be used. Preferred substrates for use in display applications are for example glass, polynorbornene, polyethersulfone, polyethyleneterephtalate, polyimide, cellulose triacetate, polycarbonate and polyethylenenaphthalate.

The substrate may for example be in the form of a film, tape or a fibre.The fibre may for example be woven or non-woven, for example the fibre may be a polymeric fibre for example a polyolefin fibre, for example polyethylene fibre, for example a polyethylene terephthalate fibre or a polypropylene fibre, a polyamide fibre, for example nylons, a polyester fibre or a polyacrylonitril fibre or a natural fibre, or an inorganic fibre. Examples of natural fibres include but are not limited to cotton fibres, flax fibres and cellulose fibres. Examples of inorganic fibres include for example glass fibres.

Other examples of polymeric fibres include but are not limited to fibres of polymers chosen from the group of polypropylene terephthalate, polybutylene terephthalate, polyacrylonitrile, polyvinylidene fluoride, polyacrylic acid, polymethyl methacrylate, polystyrene, polycarbonate, polyvinyl chloride, polyurethanes, polyimides, aramides, polybenzoxazoles, polyvinylpyrrolidone, polyethyleneimides, polyoxyethylene, poly(vinyl acetate), polyethylene glycol, polyglycolicacid, polylactic acid, polybutylene terephthalate, polymethylpentene, polybenzimidazoles, polybenzoxazoles, polyvinyl alcohol, polyaniline, poly(hydroxybutyric acid), poly(ethylene oxide), polypeptides, copolymers of these materials and mixtures of these materials.

The invention therefore also relates to the process of the invention, wherein the substrate is a fibre. Within the context of the present invention, a fibre is understood to mean an elongated body having length dimension much greater than its cross section dimensions. Fibres include both staple fibres and much longer filament fibres. Fibres can be monofilament or multifilament, and can be of any shape or cross-section. Fibres may also be hollow.

The relief structure on the fibre introduces many new functionalities in fibres and fabrics prepared from said fibres. For instance, the fibres and textiles can get new angular-dependent optic effects based on diffraction of visual light through creating diffractive structures on the surface of fibres. Traditionally the micro- and/or- nano-structuring of fibres is performed by using specific die design which can yield a surface structure in a single dimension i.e. along the fibre length. The micro- and/or- nano-structuring of fibres perpendicular to fibre axis is technologically far more difficult. At this moment, it is mainly performed via mechanical embossing of fibres (M. Halbeisen and H. Schift, Chemical-Fibres-International, 2004, 54, 378). However, mechanical embossing is usually very difficult in multifilament yarns and the method is hard to implement in a high-speed continuous spinning line. Consequently, a need persists for a non-contact, micro- and/or nano-structuring technique for fibres which are compatible with the existing spinning facilities.

It is therefore to be noted that the process of the invention works especially well for providing patterns on fibres, such as multifilament yarn, which was hitherto not possible in a continuous process. Therefore, until the process of the invention, which is a continuous process it was impossible to obtain long thin structures coated with a relief structure.

Therefore, the invention also relates to a fibre coated with a relief structure having a ratio of the length to the largest cross-section dimension of at least $1.10^6$, wherein the largest cross-section dimension of the coated fibre is in the range from 10 to $100.10^{-6}$m, for example to $50.10^{-6}$m and wherein the largest cross-section dimension varies along the fibre at regular intervals.

Preferably, the difference in size between the smallest largest cross-section dimension and the largest largest cross-section dimension in the relief structure is at least 10%, for example at least 20% and/or for example at most 100%, for example at most 50%.

With largest cross-section dimension is meant the largest dimension (diameter if the cross section is substantially circular) of the cross-section.

The variation of the largest cross-section along the fibre is due to the relief pattern, which can be achieved by the process of the invention.

The fibre can have many differently shaped cross-sections, for example the cross-section of the fibre may be circular, ellipsoidal, star-shaped, cross-shaped, triangular, cuboid, rectangular, etc.

The fibre of the invention is capable of diffracting light and therefore has optical properties, which makes the fibre of the invention suitable for the uses as described herein.

Photo-embossing is a comparatively new technique to produce the relief structures on the surface of the fibres. One of the main advantages of photo-embossing is that it generates micro- and/or nano- structures without etching procedures which facilitates incorporation of this process in spinning lines. The typical photo-embossing process is a simple procedure which consists of exposure and thermal development (K. Hermans, F. K. Wolf, J. Perelaer, R. A. J. Janssen, U. S. Schubert and C. W. M. Bastiaansen, Applied Physics Letters, 2007, 91, 1 and C. Sanchez, B. Gans, D. Kozodaev, A. Alexeev, M. J. Escuti, C. Heesch, T. Bel, U. S. Schubert, C. W. M. Bastiaansen and D. J. Broer, Advanced Materials, 2005, 17, 2567).

The composition comprising the polymeric binder, the photoinitiator and the compound having at least two crosslinkable groups per molecule was once directly utilized to melt spin photopolymer fibres. Obtained photopolymer fibres were photo-embossed via a mask exposure and thermal developed at high temperature. After flood exposure, a patterned single component fibres were obtained (M. Dai, O. T. Picot, N. F. Hughes-Brittain, T. Peijs and C. W. M. Bastiaansen, J. Mater. Chem., 2011, 21 (39), 15527 — 15531). However, such kind of patterned single component fibres are quite brittle because of the highly crosslinked system in the fibre.

Therefore, it is preferred to use a fibre as a substrate and to coat this (core) fibre with the composition comprising the polymeric binder, the photoinitiator and the compound having at least two crosslinkable groups per molecule (the functional coating). The (core) fibre generates the mechanical stability and the composition comprising the polymeric binder, the photoinitiator and the compound having at least two crosslinkable groups per molecule is applied to generate a diffractive grating structure on the surface of fibre via a photo-embossing procedure. Coating of the fibre may be performed using any of the techniques described herein, for example by using bicomponent extrusion.

The process of the invention, wherein the coated substrate is exposed to a pulsed interference pattern may be especially suitable for implementation in a (high speed) continuous spinning line. Different grating spacing structures may be obtained via changing the recording angle between the two pulsed coherent light beams creating the pulsed interference pattern.

This as opposed to photo-embossing process via a mask exposure which requires a new mask for every new spacing. Another disadvantage, not present in the process of the present invention, for the photo-embossing via a mask exposure is that when using a mask with small-size periodic structures, diffraction of light occurs, which will influence the creation of the relief structure on the substrate.

In another aspect, the invention also relates to a substrate coated with a relief structure obtainable or obtained by the process of the invention.

In another aspect, the invention also relates to the use of the fibres of the invention, of the fibres obtainable or obtained by the process of the invention in designer textiles, non-wovens, filters, scaffolds, such as scaffolds for tissue engineering, membranes, wave guides. In yet another aspect, the invention relates to the use of a film or tape coated with a relief structure obtainable or obtained by the process of the invention in for example cell adhesion, as anti-fouling or antireflective coating in micro optical elements, such as micro lenses, waveguides or solar cells.

To influence the shape and dimensions of the relief structure on the substrate, routine experimentation may be performed by the person skilled in the art. For example by optimizing the processing conditions (air or nitrogen environment, etc.) and/or the chemical composition of the composition comprising the polymeric binder, the photoinitiator and the compound having at least two crosslinkable groups per molecule. The optimization may be done by choice of polymeric binder, the (amount of ) photoinitiator and the compound having at least two crosslinkable groups per molecule and optionally further additives present in said composition and/or by changing the illuminations conditions.

It is noted that the invention relates to all possible combinations of features recited in the description, including the combination of features recited in the claims.

The invention will now be further elucidated by way of the following examples without however being limited thereto.

Examples

Brief description of the figures

Figure 1 (Fig. 1) shows the height of relief height as function of energy dose. A static (v = 0 m.s$^{-1}$) (■) and a dynamic (v = 0.05 m.s$^{-1}$) (●) substrate were exposed with a continuous wave interference pattern.

Figure 2 (Fig. 2) shows the height of relief height as function of energy dose. A static (v = 0 m.s$^{-1}$) (■) and a dynamic (v = 0.05 m.s$^{-1}$) (●) substrate were exposed with a pulsed laser interference pattern.

Figure 3 (Fig. 3) schematically represents three sets of gratings recorded using a pulsed holographic setup working at 10Hz repetition rate.

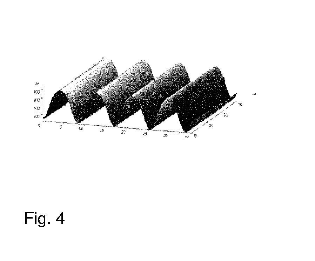

Figure 4 (Fig. 4) shows a representative Atomic Force Microscope (AFM)-profile of a surface relief structure produced with pulsed laser interference holography and a moving substrate.

Figure 5 (Fig. 5) shows the relief height as a function of energy dose for PMMA film.

Figure 6 (Fig. 6) is a representative AFM profile of a surface relief structure produced with pulsed laser interference holography on a PET coated fibre. Pitch is 8.5$\mu$m.

Figure 7 (Fig. 7) is the SEM image of the relief structure on the fibre surface a) 380x b0 2920x

Experimentals Section 1

1.1 Photopolymer preparation

Polybenzyl methacrylate (PBMA) (Scientific Polymer Products, weight-average molecular weight (Mw) 70.000 g mol$^{-1}$), dipentaerythritol penta-/hexa-acrylate (Aldrich) and Irgacure 369 photoinitiator (Ciba) were used as received. Photopolymer solutions were prepared by dissolving the binder PBMA and the monomer in a 1:1 weight ratio and adding 5 wt. % of photoinitiator, in propylene glycol monomethyl ether acetate (PGMEA). The obtained solution was spin coated on glass substrates, and the solvent was evaporated at 80 °C for 10 min to give films with an average thickness of 10 $\mu$m.

1.2 Surface relief structuring

Photoembossed films were made with two types of lasers: an argon continuous wave (CW) laser with a wavelength of $\lambda$ = 351 nm and a pulsed Nd:Yag laser coupled to second and third harmonic modules emiting 4 ns pulses of 355 nm linearly polarized light with vertical polarization (repetition rate 10 Hz). In both set-ups, CW and pulsed laser, the beam was split into equal intensity beams which were made to interfere on the substrate. The angle between the two interfering beams was 2.5° resulting in a grating period of 8 $\mu$m. The exposure of the film to the UV pattern is performed in two conditions: with a static substrate and with a moving substrate with a speed of 0.05 m.s$^{-1}$. In the latter case the displacement of the substrate is done in a direction parallel to the grating vector.

After exposure, the samples were heated to 80 °C during 10 min for development (according to C. Sanchez, B.-J. de Gans, D. Kozodaev, A. Alexeev, M. J. Escutti, C. van Heesch, T. Bel, U. S. Schubert, C. W. M. Bastiaansen, D. J. Broer, Adv. Mater. 2005, 17, 2567). The obtained structures were fixed using a flood exposure with a UV Exfo Mercury lamp (100mW.cm$^{-2}$) for 10 min and a subsequent heating step at 80ºC. (C. Sanchez, B.-J. de Gans, D. Kozodaev, A. Alexeev, M. J. Escutti, C. van Heesch, T. Bel, U. S. Schubert, C. W. M. Bastiaansen, D. J . Broer, Adv. Mater. 2005, 17, 2567).

**1.3 Relief structure characterization**

**The height of the relief structures was measured using a NMDT AFM in semi-contact mode.**

**1.4 Results and Discussion**

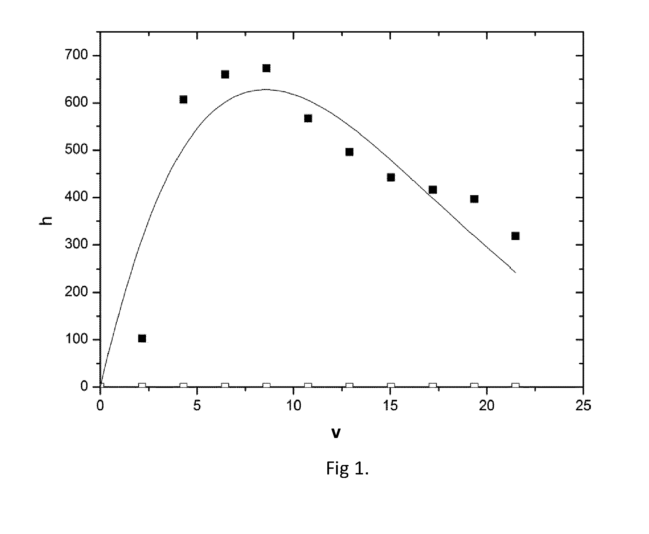

Surface relief structures on photopolymer films are obtained by combining photoembossing with interference holography. In a first set of experiments, an interference pattern is generated with two coherent, equal intensity, linearly polarized beams coming from a CW laser. In figure 1, the height of the relief structures is plotted as a function of exposure energy for a static substrate (v = 0 m.s$^{-1}$) and a moving substrate (v = 0.05 m.s$^{-1}$) simulating conditions in a roll-to-roll process. It is clear that relief structures are obtained with a static substrate while moving (translational motion) the substrate during the exposure to an interference pattern from a continuous wave laser does not produce surface relief structures at all.

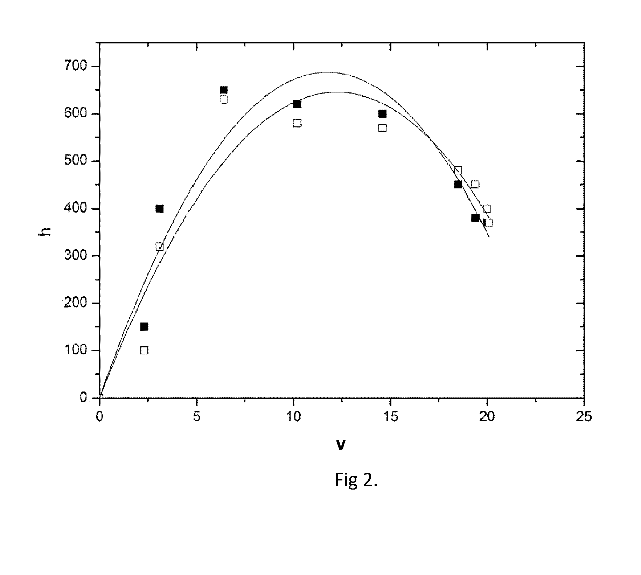

In a subsequent set of experiments, interference patterns were generated with a 4 ns pulsed laser. Again, a comparison is made between static and dynamic substrates (figure 2). It is shown that the pulsed laser experiments produce the desired relief structures in both static and dynamic substrates and this in rather sharp contrast with the experiments done with a continuous laser (see figure 1).

In order to generate a well defined pattern of radicals and therefore create relief structures on a moving substrate, the exposure time is preferably short enough to obtain a small the displacement of the substrate during exposure compared to the grating pitch. The displacement of the substrate during the exposure to a pulsed interference pattern is given by equation 3:

$$l = v.t \quad l = \dot{\mathcal{E}} \times t \text{ equation (3)}$$

wherein l is the displacement of the substrate (m), wherein v stands for the speed of the substrate (m.s$^{-1}$) and $t$ is the pulse duration (s). In our experiments, v$\dot{\mathcal{E}}$ =0.05 m.s$^{-1}$ and t = 5.10$^{-9}$s and, therefore, the substrate displacement during the pulsed exposure is only 0.25 nm. We employed an interference pattern with a pitch of 8000 nm which illustrates that the displacement of the substrate during exposure is small in comparison to the pitch. The sample can be considered to be nearly static during the 4ns duration of the pulse and therefore the same relief modulation is obtained in dynamic and static substrates.

The above-described experimental data indicate that pulsed laser interference holography is an excellent tool for generating relief structures in classical continuous film lines.

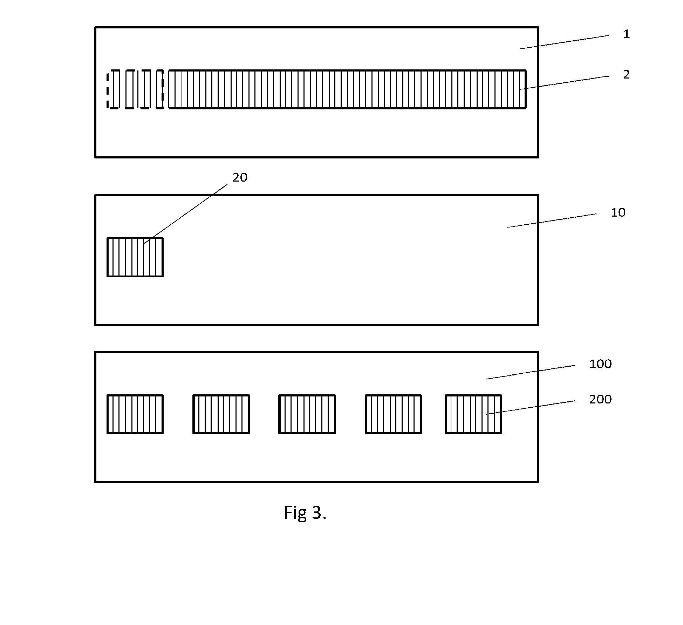

In figure 3, in the top picture it is indicated that in case the speed (v in m.s$^{-1}$) of the coated substrate (1) with respect to the pulsed interference pattern equals v(max), a continuous relief pattern (2) will be obtained on the substrate. The area indicated with the dotted lines corresponds to the area of the interference pattern. In case the substrate (10) is not moved in respect to the pulsed interference pattern, only an area equal to the interference pattern (20) will have a relief pattern (second picture from the top). In case the substrate (100) is moved at a speed higher then v(max), the relief pattern (200) on the substrate will have gaps with no pattern at regular intervals on the substrate (third picture from the top).

Equation (1) below expresses the optimal speed of the substrate v(max) (m.s$^{-1}$) in order to fully cover a moving film with surface relief structures without overlapping of contiguous gratings. This speed is a function of the repetition rate of the laser $f_{pulse}$ (Hz), the diameter of the laser beam $d_{beam}$ (m) and the beam expansion factor c (-). The size of the beam at the interference region where the sample is placed is denoted as $d_{hologram}$. $d_{hologram}$ was calculated as disclosed herein.

Equation 1:

$$v(max) = f_{pulse} \times d_{beam} \times c \qquad\qquad \text{equation (1)}$$

wherein v(max) stands for the optimal speed of the substrate in m.s$^{-1}$, wherein $f_{pulse}$ stands for the repetition rate of the lasers (Hz) and $d_{beam}$ stands for the width of the laser beams in m and
wherein c stands for the ratio between $d_{hologram}$ and $d_{beam}$ according to the equation (2)

$$c = d_{hologram} / d_{beam} \qquad\qquad \text{equation (2)}$$

wherein $d_{hologram}$ stands for the size of the beam at the interference region where the sample is placed in m and wherein $d_{beam}$ stands for the width of the laser beams in m.

The laser used herein produces light pulses with a $6 \times 10^{-3}$ m diameter beam and a repetition rate of 10 Hz (see experimental section), limiting the maximum speed of the substrate, without beam expansion (c=1), to $6 \times 10^{-2}$ m.s$^{-1}$.

This maximum speed of the substrate can be increased in a variety of ways. For instance, the laser beam can be expanded with the proper optical components. However the energy at the film should be kept high enough to generate a high modulation surface relief grating. The laser beam used in our experiments can be expanded by a factor 3.5 leading to an optimum energy (~8 mJ.cm$^2$) in the sample for generating relief structures (with maximum height; see figure 2) when the laser works at full energy. This leads to a maximum line speed of $2 \times 10^{-1}$ m.s$^{-1}$.

Other ways to further increase the maximum speeds are to reduce the optimum energy by optimalization of the composition comprising the polymeric binder, the photoinitiator and the compound having at least two crosslinkable groups per molecule or by the use of a more powerful or higher repetition rate laser.

Conclusion

It was shown that we surface relief structures can be made in a moving photopolymer film using a pulsed laser interference holography. This experimental observation proves that relief structures can be produced in a continuous operation such as a roll-to-roll process. At optimized conditions, the relief structures are nearly identical to the structures obtained with a static substrate. The system is insensitive to vibrations in comparison to continuous wave recording, being this an interesting aspect in industrial applications.

The following experiments relate to the use of the process of the invention on fibres coated with a composition comprising a polymeric binder, a photoinitiator and a compound having at least two crosslinkable groups per molecule.

Photopolymer film preparation

Polybenzyl methacrylate (PMMA) (Aldrich, weight-average molecular weight (Mw) 120.000 g mol$^{-1}$), dipentaerythritol penta-/hexa-acrylate (Aldrich) and Irgacure 369 photoinitiator (Ciba) were used as received. Photopolymer solutions were prepared by dissolving the binder PMMA and the monomer in a 1:1 weight ratio and adding 5 wt.% of photoinitiator, in propylene glycol monomethyl ether acetate (PGMEA). The obtained solution was spin coated on glass substrates, and the solvent was evaporated at 80 °C for 10 min to give films with an average thickness of 10 $\mu$m.

The fibres were prepared by spraying a 1:40 photopolymer solution on a PET monofilament with a diameter of 185 $\mu$m. The solvent was evaporated in an oven at 80 °C for 10 min.

Surface relief structuring

The surface structures on PMMA films were obtained following the same protocol as for the PBMA films done in static conditions, except the developing temperature was 130°C (instead of 80°C).

For the fibre, the structures were obtained using the optimal energy dose for the film (80mJ/cm$^2$) and successively developed at 130°C and then cured following the standard protocol as used above.

Measurements

The height of the relief structures was measured using a NMDT AFM in semi-contact mode. SEM images were obtained using the desktop SEM Phenom G2 pro.

Results

Film

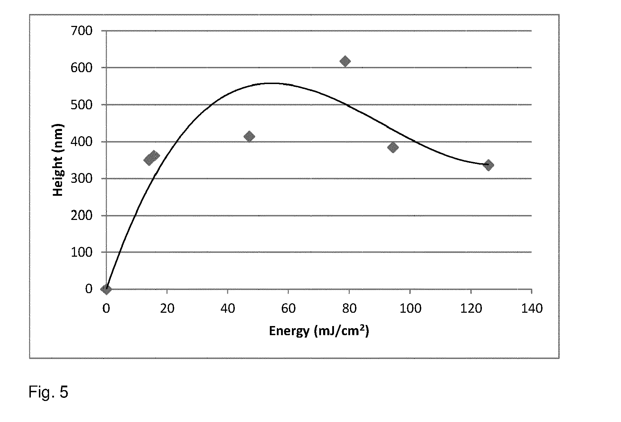

The relief height as a function of the energy dose for a PMMA flm is given in Figure 5 (Fig. 5).

Fibre

The structures on the fibre are slightly lower than for the film. Exposing the fibre to an energy of gave a relief height of 350$\mu$m. The difference probably comes from the inhomogeneity of the laser beam on the film exposed for the same conditions the height varies from 300$\mu$m to 600$\mu$m depending on the scanned area. If the fibre is not placed exactly in the optimum position with regards to the energy profile of the laser beam then the height can vary.

Although this experiment was performed using a monofilament, it is clear to the skilled person that this can also be performed on a longer fibre, for instance on a fibre that moves in a spinning line.

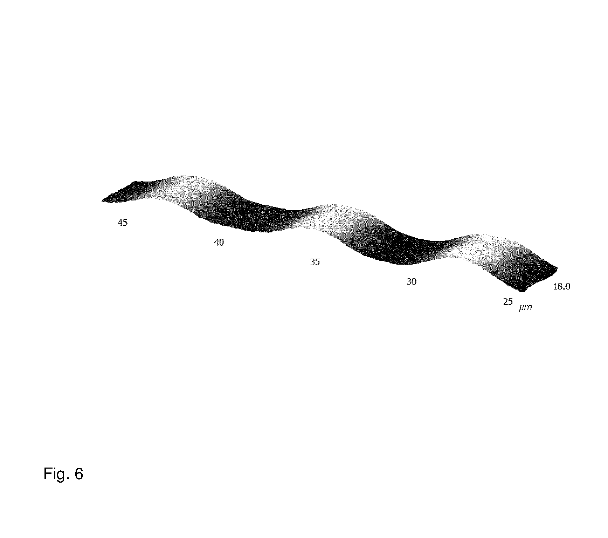

Figure 6 (Fig. 6) shows a representative AFM-profile of a surface relief structure produced with pulsed laser interference holography on a PET coated fibre. Pitch is 8.5$\mu$m.

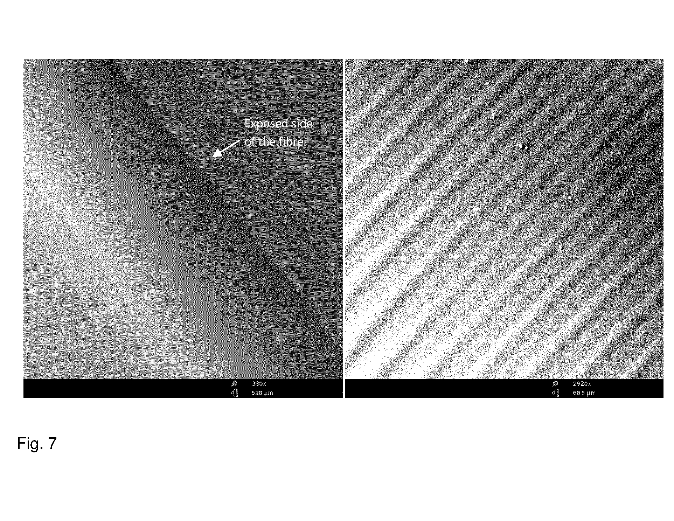

Figure 7 (Fig. 7) is a SEM image of the relief structure on the fibre surface a) 380x b0 2920x.

As can be seen from Figure 6 (Fig. 6) and Figure 7 (Fig. 7), the variation of the largest cross-section dimension varies at regular intervals.

## Claims

1.    Process comprising the steps of

a) coating a substrate with a coating composition comprising a polymeric binder, a photoinitiator and a compound having at least two crosslinkable groups per molecule to form a coated substrate and
b) exposing said coated substrate to a pulsed light, which light is capable of activating the photoinitiator while moving said coated substrate with respect to the source of the pulsed light to obtain a substrate coated with a relief structure.

2.    Process according to claim 1, further comprising step c) of subsequently heating the product obtained in step b).

3.    Process according to claim 1 or claim 2, further comprising step d) of curing the product obtained in step b) or the product obtained in step c).

4.    Process according to any one of claims 1-3, wherein curing is performed using UV flood exposure and/or heating.

5.    Process according to any one of claims 1-4, wherein the pulsed light is a pulsed light pattern.

6.    Process according to any one of claims 1-5, wherein the pulsed light is a pulsed interference pattern created by two pulsed coherent electromagnetic radiation beams.

7.    Process according to any one of claims 1-6, wherein the coated substrate is moved with respect to the source of the pulsed light at a speed of at least 1 m/min.

8.    Process according to any one of claims 1-7, wherein the substrate is a film or a tape.

9.    Process according to any one of claim 1-7, wherein the substrate is a fibre, preferably a polymeric fibre or a natural fibre.

10.    Process according to claim 9, wherein the polymeric fibre is an polyethylene fibre, a polypropylene fibre, a polyamide fibre, a polyester fibre or a polyacrylonitril fibre.

11.    Substrate coated with a relief structure obtainable by the process of any one of claims 1-10.

12.    Fibre coated with a relief structure having a ratio of the length to the largest cross-section dimension of at least $1.10^6$, wherein the largest cross-section dimension is in the range of from 10 to $100.10^{-6}$m and wherein the largest cross-section dimension varies along at least part of the fibre at regular intervals.

13.    Fibre according to claim 12, wherein the difference in size between the smallest largest cross-section dimension and the largest largest cross-section dimension in the relief structure is at least 10%.

14.    Use of the fibre of claim 12 or of claim 13 or of a fibre obtainable or obtained by the process of 9 in designer textiles, non-wovens, filters, scaffolds, such as scaffolds for tissue engineering, membranes, wave guides.

15.    Use of a film or tape obtained by the process of claim 8 in for example cell adhesion, as anti-fouling or antireflective coating in micro optical elements.

Fig 1.

Fig 2.

Fig 3.

Fig. 4

Fig. 5

45

40

35

30

25 *μm*

18.0

Fig. 6

Exposed side
of the fibre

Fig. 7

Europäisches
Patentamt

European
Patent Office

Office européen
des brevets

## EUROPEAN SEARCH REPORT

Application Number

EP 11 18 9018

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | WO 2006/051484 A2 (KONINKL PHILIPS ELECTRONICS NV [NL]; MENA BENITO MARIA E [NL]; KURT RA) 18 May 2006 (2006-05-18) <br> * page 2, lines 23-31 * <br> * page 7, lines 1-4 * <br> * pages 11-14; claims 1-19; figure 3 * | 1-8,11 | INV. <br> G03F7/36 <br> G03F7/027 <br> G03F7/38 |
| Y | WITZ DE C ET AL: "PHOTO-EMBOSSING AS A TOOL FOR CREATING COMPLEX SURFACE RELIEF STRUCTURES", <br> POLYMER PREPRINTS, AMERICAN CHEMICAL SOCIETY, US, <br> vol. 44, no. 2, 1 August 2003 (2003-08-01) <br> , page 236/237, XP008044116, <br> ISSN: 0032-3934 <br> * pages 236,237 * | 1-15 | |
| Y | WO 2008/151915 A1 (STICHTING DUTCH POLYMER INST [NL]; PERELAER JOLKE [NL]; HERMANS KO [NL]) 18 December 2008 (2008-12-18) <br> * page 7, line 18 - page 8, line 3; claims 1-15 * <br> * pages 1,2 * | 1-15 | |
| Y | WO 2008/025508 A1 (STITCHING DUTCH POLYMER INST [NL]; HERMANS KO [NL]; BASTIAANSEN CORNEL) 6 March 2008 (2008-03-06) <br> * page 8, lines 9-29; claims 1-14 * | 1-15 | TECHNICAL FIELDS SEARCHED (IPC) <br><br> G03F |
| Y | EP 2 109 005 A1 (STICHTING DUTCH POLYMER INST [NL]) 14 October 2009 (2009-10-14) <br> * paragraph [0010]; claims 1-17 * | 1-15 | |

-/--

The present search report has been drawn up for all claims

| Place of search | Date of completion of the search | Examiner |
|---|---|---|
| Munich | 23 January 2012 | Oechsner de Coninck |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

& : member of the same patent family, corresponding
document

EPO FORM 1503 03.82 (P04C01)

# EUROPEAN SEARCH REPORT

Application Number

EP 11 18 9018

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | CARLOS SANCHEZ: "Photoembossing of periodic relief structures using polymerization-induced diffusion: A combinatorial study", ADVANCED MATERIALS, vol. 17, 2005, pages 2567-2571, XP009155432, * the whole document * | 1-15 | |
| Y | WO 2004/021088 A2 (KONINKL PHILIPS ELECTRONICS NV [NL]; VAN STEENWINKEL DAVID [BE]; LAMME) 11 March 2004 (2004-03-11) * page 6, lines 27-34 * | 1-15 | |
| Y | MIAN DAI: "Formation of relief structures on fibres by photo-embossing", JOURNALS OF MATERIALS CHEMISTRY, vol. 21, 25 August 2011 (2011-08-25), pages 15527-15531, XP009155473, * page 15527 - page 15531 * | 1-15 | |
| | | | TECHNICAL FIELDS SEARCHED (IPC) |

The present search report has been drawn up for all claims

| Place of search | Date of completion of the search | Examiner |
|---|---|---|
| Munich | 23 January 2012 | Oechsner de Coninck |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 11 18 9018

This annex lists the patent family members relating to the patent documents cited in the above-mentioned European search report.
The members are as contained in the European Patent Office EDP file on
The European Patent Office is in no way liable for these particulars which are merely given for the purpose of information.

23-01-2012

| Patent document cited in search report | | Publication date | Patent family member(s) | | Publication date |
|---|---|---|---|---|---|
| WO 2006051484 | A2 | 18-05-2006 | NONE | | |
| WO 2008151915 | A1 | 18-12-2008 | AT | 487166 T | 15-11-2010 |
| | | | EP | 2019336 A1 | 28-01-2009 |
| | | | EP | 2156247 A1 | 24-02-2010 |
| | | | JP | 2010532394 A | 07-10-2010 |
| | | | US | 2010279074 A1 | 04-11-2010 |
| | | | WO | 2008151915 A1 | 18-12-2008 |
| WO 2008025508 | A1 | 06-03-2008 | CN | 101535900 A | 16-09-2009 |
| | | | EP | 2059855 A1 | 20-05-2009 |
| | | | JP | 2010501687 A | 21-01-2010 |
| | | | KR | 20090079193 A | 21-07-2009 |
| | | | US | 2010028816 A1 | 04-02-2010 |
| | | | WO | 2008025508 A1 | 06-03-2008 |
| EP 2109005 | A1 | 14-10-2009 | EP | 2109005 A1 | 14-10-2009 |
| | | | EP | 2260353 A1 | 15-12-2010 |
| | | | JP | 2011516677 A | 26-05-2011 |
| | | | US | 2011104445 A1 | 05-05-2011 |
| | | | WO | 2009124942 A1 | 15-10-2009 |
| WO 2004021088 | A2 | 11-03-2004 | AU | 2003255936 A1 | 19-03-2004 |
| | | | CN | 1678960 A | 05-10-2005 |
| | | | EP | 1537455 A2 | 08-06-2005 |
| | | | JP | 2005537507 A | 08-12-2005 |
| | | | KR | 20050033078 A | 08-04-2005 |
| | | | US | 2005268804 A1 | 08-12-2005 |
| | | | WO | 2004021088 A2 | 11-03-2004 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 0018696 A

**Non-patent literature cited in the description**

- **N. STUTZMANN ; T.A. TERVOORT ; C.W.M. BASTIAANSEN ; K. FELDMAN ; P. SMITH.** *Adv. Mater.,* 2000, vol. 12, 557
- **G. FICHET ; N. STUTZMANN ; B.V.O.MUIR ; W.T.S.HUCK.** *Adv.Mater.,* 2002, vol. 14, 47
- **E. KIM ; Y.N.XIA ; G.M.WHITESIDES.** *Nature,* 1995, vol. 376, 581
- **C. SANCHEZ ; B-J. DE GANS ; D. KOZODAEV ; A. ALEXEEV ; M.J.ESCUTI ; C. VAN HEESCH ; T. BEL ; U.S.SCHUBERT ; C.W.M.BASTIAANSEN ; D.J.BROER.** *Adv. Mater.,* 2005, vol. 17, 2567-2571
- **S.H. AHN ; L.J. GUO.** high-speed roll-to-roll nanoimprint lithography on flexible plastic substrates. *Adv. Mater.,* 2008, vol. 20, 2044-2049
- **M. HALBEISEN ; H. SCHIFT.** *Chemical-Fibres-International,* 2004, vol. 54, 378
- **K. HERMANS ; F. K. WOLF ; J. PERELAER ; R. A. J. JANSSEN ; U. S. SCHUBERT ; C. W. M. BASTIAANSEN.** *Applied Physics Letters,* 2007, vol. 91, 1
- **C. SANCHEZ ; B. GANS ; D. KOZODAEV ; A. ALEXEEV ; M. J. ESCUTI ; C. HEESCH ; T. BEL ; U. S. SCHUBERT ; C. W. M. BASTIAANSEN ; D. J. BROER.** *Advanced Materials,* 2005, vol. 17, 2567
- **M. DAI ; O. T. PICOT ; N. F. HUGHES-BRITTAIN ; T. PEIJS ; C. W. M. BASTIAANSEN.** *J. Mater. Chem.,* 2011, vol. 21 (39), 15527-15531
- **C. SANCHEZ ; B.-J. DE GANS ; D. KOZODAEV ; A. ALEXEEV ; M. J. ESCUTTI ; C. VAN HEESCH ; T. BEL ; U. S. SCHUBERT ; C. W. M. BASTIAANSEN ; D. J. BROER.** *Adv. Mater.,* 2005, vol. 17, 2567
- **C. SANCHEZ ; B.-J. DE GANS ; D. KOZODAEV ; A. ALEXEEV ; M. J. ESCUTTI ; C. VAN HEESCH ; T. BEL ; U. S. SCHUBERT ; C. W. M. BASTIAANSEN ; D. J . BROER.** *Adv. Mater.,* 2005, vol. 17, 2567